Europäisches Patentamt

European Patent Office

Office européen des brevets

(19)

(11) **EP 1 256 005 B1**

(12) **EUROPÄISCHE PATENTSCHRIFT**

(45) Veröffentlichungstag und Bekanntmachung des Hinweises auf die Patenterteilung:
**15.10.2003   Patentblatt 2003/42**

(21) Anmeldenummer: **00984893.8**

(22) Anmeldetag: **17.11.2000**

(51) Int Cl.$^7$: **G01R 29/08**

(86) Internationale Anmeldenummer:
**PCT/DE00/04074**

(87) Internationale Veröffentlichungsnummer:
**WO 01/061366 (23.08.2001 Gazette 2001/34)**

(54) **VERFAHREN UND VORRICHTUNG ZUR ERMITTLUNG VON PHYSIKALISCHEN VEKTOREN EINES VEKTORFELDES**

METHOD AND DEVICE FOR DETERMINING PHYSICAL VECTORS OF A VECTOR FIELD

PROCEDE ET DISPOSITIF POUR DETERMINER DES VECTEURS PHYSIQUES D'UN CHAMP VECTORIEL

(84) Benannte Vertragsstaaten:
**AT BE CH CY DE DK ES FI FR GB GR IE IT LI LU MC NL PT SE TR**

(30) Priorität: **17.02.2000  DE 10007129**

(43) Veröffentlichungstag der Anmeldung:
**13.11.2002   Patentblatt 2002/46**

(73) Patentinhaber: **Universität Hannover**
**30167 Hannover (DE)**

(72) Erfinder:
  • **KÄRST, Jens, Peter**
    **22391 Hamburgr (DE)**
  • **KOWALSKI, Thomas**
    **30167 Hannover (DE)**

(74) Vertreter: **Patentanwälte Thömen & Körner**
    **Postfach 59 31**
    **30059 Hannover (DE)**

(56) Entgegenhaltungen:
WO-A-93/18558     DE-A- 4 214 585
GB-A- 1 279 621    US-A- 4 588 993
US-A- 5 404 098

• BRONAUGH E L: "SIMPLIFYING EMI IMMUNITY (SUSCEPTIBILITY) TESTS IN TEM CELLS" PROCEEDINGS OF THE INTERNATIONAL SYMPOSIUM ON ELECTROMAGNETIC COMPATIBILITY,US,NEW YORK, IEEE, Bd. -, 21. August 1990 (1990-08-21), Seiten 488-491, XP000224687
• SUGIURA A ET AL: "CURRENT TOPICS OF MICROWAVE EMI ANTENNAS AND MEASUREMENTS" IEICE TRANSACTIONS ON COMMUNICATIONS,JP,INSTITUTE OF ELECTRONICS INFORMATION AND COMM. ENG. TOKYO, Bd. 80-B, Nr. 5, 1. Mai 1997 (1997-05-01), Seiten 653-661, XP000723038 ISSN: 0916-8516

**Beschreibung**

Die Erfindung betrifft ein Verfahren zur Ermittlung von gerichteten physikalischen Größen, die durch Vektoren eines quasi-stationären harmonischen Vektorfeldes an einem Messort beschreibbar sind nach dem Oberbegriff des Anspruchs 1 und eine entsprechende Vorrichtung nach dem Oberbegriff des Anspruchs 8.

Die Prüfung elektronischer Geräte auf elektromagnetische Verträglichkeit erfordert Messungen und Analysen in einem elektromagnetischen Vektorfeld. Für reproduzierbare Ergebnisse und insbesondere zur Prüfung der Einhaltung gesetzlicher Vorschriften ist die Kenntnis der Feldstärke derartiger Vektorfelder und deren Homogenität erforderlich. Zur Prüfung kleinerer Objekte sind Messungen in Absorberhallen oder gar Freifeldmessungen nicht nötig. Vielmehr reichen hier Messzellen. aus, die z. B. nach dem Prinzip eines sich pyramidenförmig aufweitenden transversal-elektro-magnetischen (abgekürzt TEM) Wellenleiters aufgebaut sind. Zur Prüfung der Eignung solcher TEM-Wellenleiter sowie der Ermittlung der Homogenität und zur Kalibrierung ist es nötig, die Feldstärke an verschiedenen Orten in Betrag und Richtung messen zu können. Dabei soll eine möglichst genaue Messung bei möglichst geringer Beeinflussung des elektromagnetischen Feldes der Messzelle durch die Messvorrichtung selbst erzielt werden.

Aus der US 5 404 098 A ist ein Verfahren und eine Vorrichtung zur Korrelation von Messungen eines elektromagnetischen Vektorfeldes bekannt. Hierbei werden mit einer Antennenanordnung die Feldstärkebeträge in jeweils zwei Polarisationsrichtungen an den sechs Seitenflächen eines gedachten Würfels vorgenommen. Durch Maximumfindung, eventuelles zusätzliches Drehen des Würfels um 45° sowie Auswertung der einzelnen Komponenten der Spannungswerte der Würfelflächen wird so der resultierende Vektor der elektromagnetischen Feldstärke ermittelt.

Aus der US 4 588 993 eine Messanordnung bekannt, bei der eine gleichzeitige Messung der elektrischen und magnetischen Komponenten eines elektromagnetischen Vektorfeldes ermöglicht wird. Die Ausgangsspannungen der Messelemente in Form von jeweils drei Dipolen und jeweils drei Leiterschleifen können als Summe oder auch in beliebiger Kombination gemessen und die Messwerte gespeichert werden. Eine Auswertung zur Ermittlung eines resultierenden Vektors aus den Komponenten ist nicht beschrieben.

Aus E. L. Bronaugh, "Simplifying EMI Immunity (Susceptibility) Tests in TEM Cells", Proc. of the Inernational Symposium on Electromagnetic Compatibility, pages 488 to 491, New York, 1990 ist eine Messanordnung zur Bestimmung der Störfestigkeit eines Prüflings bekannt. Einzelne elektrisch leitende Teile des Prüflings werden mit Antennen verglichen. Es wird gezeigt, dass bei einer 360° Drehung des Prüflings und einer Neigung von 54,7356° zur Drehachse alle Antennen - über die Rotationsdauer gemittelt - der gleichen Gesamtfeldstärke ausgesetzt sind.

In A. Sugiura et al., "Current Topics of Microwave EMI Antennas and Measurements", IEICE Transactions on Communications, Band 80-B, Nr. 5, pages 653 to 661, Tokyo, 1997 ist der Aufbau von Sensoren zur Erfassung der Feldstärke elektrischer Wechselfelder mittels kleiner Dipol-Antennen beschrieben. Ferner befasst sich diese Druckschrift mit der Signalübertragung vom Sensor zu einem Sender oder Empfänger über optische Signalleitungen unter Zwischenschaltung elektro-optischen Umsetzern.

T. E. Batchman et al., "An Implantable Electric-Field Probe of Submillimeter Dimensions", IEEE Transactions on Microwave Theory and Techniques, Band 31, Nr. 9, pages 745 to 751, US, 1983 befasst sich mit der Konstruktion, Herstellung und Prüfung von Sensoren zur Erfassung der Feldstärke elektrischer Wechselfelder mittels kleiner Dipol-Antennen. Dabei ist auch erwähnt, eine Dipol-Antenne zur Messung von drei orthogonalen Feldkomponenten eines elektrischen Wechselfeldes zu verwenden, indem die Dipol-Achse unter einem Winkel von 54° zur Drehachse ausgerichtet wird.

Der Erfindung liegt die Aufgabe zugrunde, ein Verfahren und eine Vorrichtung zur Ermittlung von gerichteten physikalischen Größen, die durch Vektoren eines quasi-stationären harmonischen Vektorfeldes an einem Messort beschreibbar sind, anzugeben, welche für alle Vektorkomponenten identische Mess-Eigenschaften aufweist und eine geringere Rückwirkung der Messanordnung auf das Vektorfeld bewirkt.

Diese Aufgabe wird bei einem Verfahren nach dem Oberbegriff des Anspruchs 1 durch die Merkmale dieses Anspruchs und bei einer Vorrichtung nach dem Oberbegriff des Anspruchs 8 durch die Merkmale jenes Anspruchs gelöst.

Weiterbildungen und vorteilhafte Ausgestaltungen der Erfindung ergeben sich aus den Unteransprüchen.

Bei der erfindungsgemäßen Lösung werden alle drei Komponenten des Vektors nur mit einem einzigen Messsensor erfasst, der bei einer Messung jeweils nur eine Koordinatenachse des Vektorfeldes erfasst. Dieser Messsensor wird nacheinander in drei Richtungen positioniert, die jeweils orthogonal zu den beiden anderen Richtungen weisen. Auf diese Weise werden alle drei Vektorkomponenten mit demselben Messsensor erfasst, so dass völlig identische Mess-Eigenschaften vorhanden sind. Da sich jeweils nur ein Messsensor im Vektorfeld befindet, tritt außer der unvermeidlichen Feldverzerrung durch den Messsensor selbst keine weitere Rückwirkung durch andere Messelemente ein, die zu der betreffenden Messrichtung nichts beitragen. Im Zusammenhang mit den Messungen bedeutet quasi-stationär, dass das Vektorfeld wenigstens für die Dauer der Messungen stationär ist.

Eine besonders hohe Genauigkeit wird dadurch erzielt, dass die drei orthogonal zueinanderweisenden Positionen durch Drehung des Messsensors lediglich um eine Achse angefahren werden. Dabei ist der Messsensor zu der Drehachse im Winkel von 90° - arctan $\sqrt{0,5}$ geneigt. Dieser Winkel entspricht demjenigen Winkel, den die Kanten eines Würfels mit der sie schneidenden Diagonalen einschließen. Eine Projektion in Richtung dieser Diagonalen zeigt, dass die Kanten eines solchen auf der Spitze stehenden Würfels jeweils durch eine Drehung um 120° ineinander überführt werden können. Dementsprechend kann ein derartig angeordneter und geneigter Messsensor durch Drehen um jeweils 120° nacheinander alle drei Positionen anfahren, die jeweils orthogonal zu den restlichen zwei Positionen weisen. In der Praxis sind natürlich Abweichungen vom exakt berechneten Neigungswinkel unvermeidbar. Die Größe der Abweichungen hat Einfluß auf die Messgenauigkeit, so dass die Tolranzen so klein gehalten werden müssen, dass sie noch innerhalb des Toleranzbereichs der gewünschten Messgenauigkeit liegen.

Da die vom Messsensor in elektrische Größen umgesetzte physikalische Größen des Vektorfeldes erst nach einer Gleichrichtung gemessen werden, geht die Polarität verloren, so dass bei einer vektoriellen Addition der gemessenen Komponenten Vektoren ermittelt werden, die mehrdeutig sind, das heißt. acht mögliche Richtungen einnehmen können. Allerdings wird ein harmonisches Vektorfeld betrachtet, so dass lediglich die Gerade von Interesse ist, auf der die Vektoren liegen. Dadurch reduziert sich die Anzahl der möglichen Vektoren auf vier. Durch zwei weitere Messungen bei unterschiedlichen Winkeln ergeben sich wieder mehrere Lösungsmöglichkeiten, von denen allerdings einige identisch sind. Durch Bildung einer Schnittmenge aus den mehrdeutigen Vektoren werden die für alle Messungen gemeinsamen Vektoren, also diejenigen, die in ihrer Richtung identisch sind, ausgewählt. Sie geben dann die tatsächliche Richtung des Vektors an.

Gemäß einer Weiterbildung werden mittels einer rechnerisch oder empirisch ermittelten Übertragungsfunktion die physikalischen Größen des Vektorfeldes aus den gemessenen elektrischen Größen durch ein Messgerät oder einen Rechner bestimmt.

Durch diese Übertragungsfunktion wird der Einfluss des Messsensors, der Zuleitung zum Messgerät sowie eventuell vorhandener Filter berücksichtigt.

Bei einer praktischen Ausführung zur Messung eines elektromagnetischen Vektorfeldes kann als Messsensor ein elektrischer Dipol , in den als elektrische Größe eine Spannung influenziert wird, oder ein magnetischer Dipol dienen, in den als elektrische Größe ein Strom induziert wird.

Weiterhin können die physikalischen Größen der Vektorkomponenten in ein Bezugs-Koordinatensystem übertragen werden, bei dem die Drehachse des zur Messung dienenden Messsensors orthogonal zur Bezugsebene innerhalb des Bezugs-Koordinatensystems weist.

Es lässt sich hierdurch der Vektor in Bezug auf Winkel und Betrag im Bezugs-Koordinatensystem angeben.

Gemäß einer Weiterbildung können die zwei weiteren Messungen von Komponenten des Vektors bei dem. Maximum und dem Minimum des Messwertes über einer 360°-Drehung des Messsensors um dieselbe Drehachse vorgenommen werden. Zwischen dem Maximum und dem Minimum liegen stets 180°.

Die Rechnung vereinfacht sich dann dadurch, dass der Drehwinkel aus dem Drehwinkel des Maximums bzw. Minimums und der Neigungswinkel gegenüber der Drehebene durch den arccos des Betrages des in der Drehebene liegenden Minimums bzw. Maximums zum Betrag des Vektors bestimmt werden können. Jede Rechnung ergibt dann vier Lösungsmöglichkeiten für den Neigungswinkel und die Schnittmenge aus beiden Rechnungen liefert einen einzigen Neigungswinkel. Der zugehörige Drehwinkel in der Drehebene entspricht dem Drehwinkel des Maximums.

Zur Bestimmung des Maximums und des Minimums ist es möglich, . die Messungen von Komponenten des Vektors in wenigstens fünf über einer 360°-Drehung des Messsensors verteilten Drehpositionen vorzunehmen und Zwischenwerte durch Interpolation zu ermitteln.

Diese Maßnahme reduziert die Anzahl der vorzunehmenden Messungen und ermöglicht so eine Reduzierung des Zeitaufwandes, der bei einer Vielzahl von Messungen an unterschiedlichen Positionen zum Trägen kommt.

Weiterhin kann eine Fehlerfortpflanzung der einzelnen Fehler auf die Ergebnisse der mit dem einzigen Messsensor durchgeführten Messungen unterschiedlicher Richtungen bestimmt werden und aus der Schnittmenge der in demselben Halbraum des. Bezugs-Koordinatensystems liegenden Werte derjenige übernommen werden, der den geringsten relativen Fehler aufweist.

Aufgrund von Messfehlern sind die die Schnittmenge bildenden Richtungen nicht immer identisch. Unter Berücksichtigung der Fehlerfortpflanzung gelingt es, aus den dicht beieinanderliegenden errechneten Werten denjenigen auszuwählen, der den geringsten erwarteten Fehler aufweist, um dadurch die maximal mögliche Genauigkeit zu erzielen.

Gemäß einer Weiterbildung umfasst der Antrieb einen Schrittmotor. Bei dieser Antriebsart ist eine genaue Positionierung unmittelbar durch die Steuerung, das heißt ohne eine Rückführung möglich. Durch eine entsprechende Übersetzung kann dann auch die Anzahl der möglichen Positionen innerhalb eines vollständigen Umlaufs an die Systemgenauigkeit angepasst werden. Dementsprechend wird die Schrittweite der möglichen Positionen so gewählt, dass sie etwa im Bereich der Messauflösung der übrigen Größen liegt. Dadurch wird eine ausreichende Genauigkeit geschaffen, die auf eine zu feine Winkelpositionierung verzichtet. Durch eine zu feine Winkelpositionierung wird nämlich nur die Messzeit vergrößert, nicht aber die Messgenauigkeit gesteigert.

Gemäß einer Weiterbildung der Vorrichtung ist ein Gleichrichter an einem Fußpunkt des zur Messung dienenden Messsensors angeschlossen und über eine symmetrische Widerstandsleitung mit dem Messgerät verbunden.

Der Gleichrichter ist damit im Messsensor integriert und führt zu keiner wesentlich größeren Rückwirkung auf das zu messende Vektorfeld als der Messsensor selbst. Durch die Integration ist auch keine hochfrequenzoptimierte Ableitung der elektrischen Größe nötig, denn diese hätte aufgrund guter elektrischer Leitfähigkeit zwangsläufig starke Rückwirkungen auf das Vektorfeld zur Folge. Vielmehr kann eine widerstandsbehaftete Leitung für die Übertragung der gleichgerichteten elektrischen Größe vorgesehen werden. Diese zeichnet sich durch eine geringe Rückwirkung aus.

Weiterhin ist es möglich, dass der Messsensor, sein Antrieb, das Messgerät und ein Steuerrechner ein separates Modul bilden, das über Lichtleiter mit einem Auswerterechner verbunden ist.

Bei dieser Ausbildung wird der unbedingt nötige Schaltungsaufwand in der Nähe des Messsensors konzentriert. Hingegen gibt es für eine Verbindung mit dem Auswerterechner keinerlei Leitungselemente, die das Vektorfeld beeinflussen. Auf diese Weise wird der unvermeidbare Einfluss der Messanordnung auf das Vektorfeld auf das absolut notwendige Minimum beschränkt.

Nachfolgend wird die Erfindung anhand eines Ausführungsbeispiels erläutert, das in der Zeichnung dargestellt ist. In der Zeichnung zeigen:

Fig. 1    ein Blockschaltbild einer Messanordnung und
Fig. 2    eine Darstellung des Moduls mit dem als Messaufnehmer dienenden Messsensor.

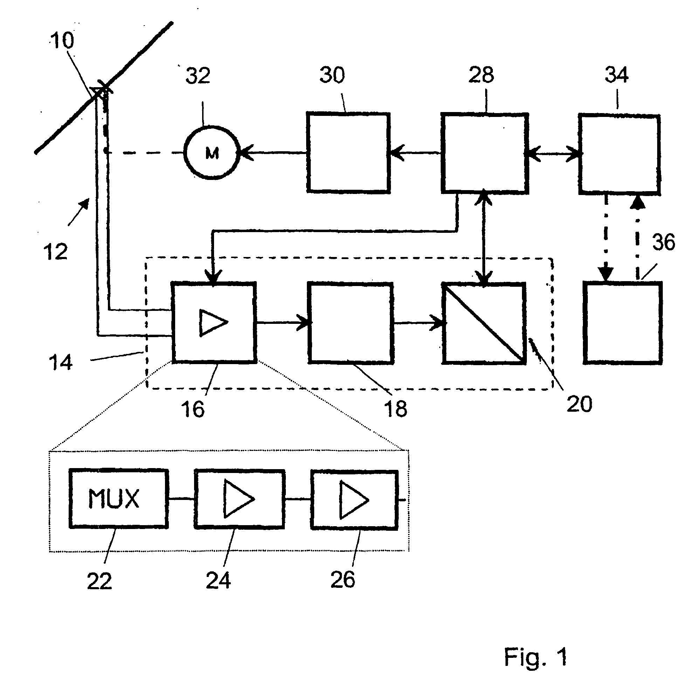

In Fig. 1 ist ein Blockschaltbild einer Messanordnung dargestellt, die aus einem separaten Modul mit einem Dipol 10 als Messsensor und einem Auswerterechner 36 besteht. Der Dipol 10 ist ein kurzer Dipol, der aus Leiterbahnmaterial gefertigt sein kann und an dessen Fußpunkt ein Gleichrichter in Form einer Schottky-Diode angeschlossen ist.

Vom Ausgang des Gleichrichters führt eine symmetrische Widerstandsleitung 12 zu einem Messgerät 14, das einen Verstärker 16, einen Tiefpass 18 sowie einen Analog-Digital-Wandler 20 umfasst. Der Verstärker 16 kann seinerseits aus einem Multiplexer 22, einem Vorverstärker 24 und einem programmierbaren Verstärker 26 bestehen. Der Multiplexer 22 ermöglicht es, den Eingang des Messgerätes 14 wechselweise zwischen Nullpotential, dem Ausgang der Widerstandsleitung 12 und einer Referenzspannungsquelle umzuschalten, um einen Nullpunktabgleich, eine Temperaturkompensation der Verstärkerkennlinie und eine Kalibrierung durchführen zu können. Der Vorverstärker 24 dient zur Impedanzanpassung an den nachfolgenden programmierbaren Verstärker 26. Der Tiefpass 18 dient als Anti-Aliasing-Filter und zur Rauschunterdrückung. Der Analog-Digital-Wandler 20 gewinnt die für eine digitale Datenverarbeitung nötigen digitalen Werte der influenzierten Spannung. Außerdem ist der Ausgang des Analog-Digital-Wandlers 20 mit einem Steuerrechner 28 verbunden, der den programmierbaren Verstärker 26 im Verstärkungsfaktor so steuert, dass der Analog-Digital-Wandler 20 stets optimal ausgesteuert ist.

Der Steuerrechner 28 ist ferner mit einem Treiber 30 verbunden, der seinerseits einen Schrittmotor 32 zum Antrieb der hier vertikalen Drehachse des Dipols 10 steuert. Schließlich ist der Steuerrechner 28 noch mit einer Schnittstelle 34 verbunden, die über einen Lichtleiter eine bidirektionale Verbindung mit dem externen Auswerterechner 36 herstellt.

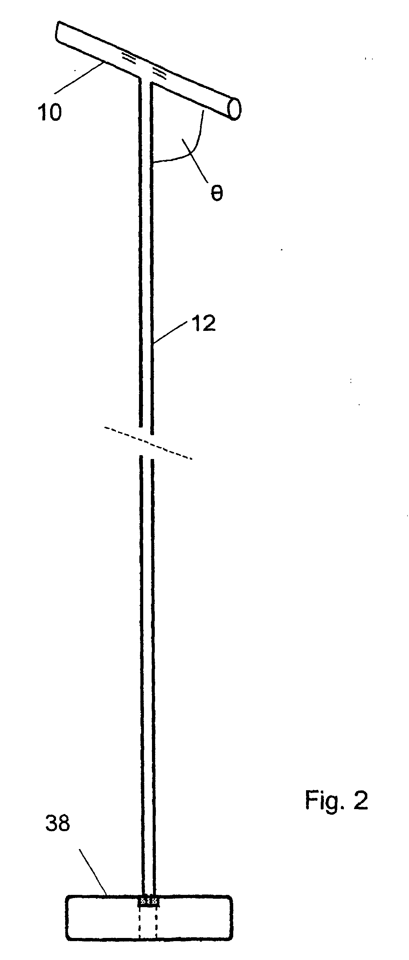

Fig. 2 zeigt eine Darstellung des Moduls 38 mit dem als Messaufnehmer dienenden Dipol 10. Das Modul nimmt in seinem Gehäuse die vorbeschriebenen elektronischen Baugruppen einschließlich des angetriebenen Endes der Antriebswelle für den Dipol 10 auf. Am freien Ende der Antriebswelle, die um die Drehachse um 360° drehbar ist, befindet sich der zur Messung dienende Dipol 10. Dieser Dipol ist in Bezug auf den zu messenden Frequenzbereich ein kurzer Dipol, dessen Wellenlänge kleiner als $\lambda/8$ der oberen Grenzfrequenz des Frequenzbereichs bemessen ist. Dieser Dipol ist zur Drehachse um den Winkel $9.0° - \arctan \sqrt{0,5} = 35,26°$ geneigt. Die vom Ausgang des: Gleichrichters zum Messgerät 14 führende Ableitung 12 besteht hier aus Graphit-Leiterbahnen auf einem starren Träger.

Um einen Bezug zwischen der gemessenen Gleichspannung und der verursachenden elektrischen Feldstärke herzustellen, besteht die Möglichkeit, Kalibrierfunktionen durch empirische Messungen mit bekannter Feldstärke aufzunehmen oder aber die Funktion rechnerisch zu ermitteln. Bei der rechnerischen Ermittlung wird der Zusammenhang $U = E * L_{eff}$ zugrundegelegt, wobei U die Leerlaufspannung, E die elektrische Feldstärke und $L_{eff}$ die effektive Länge des Dipols ist.

Zur Berechnung der effektiven Länge sowie des komplexen Fußpunktwiderstandes eines Dipols können die in der Veröffentlichung MA M. T. / Kanda M.: Electromagnetic Kompatibility and Interference Metrology, National Bureau of Standards, Technical Note 1099 (July 1986) erläuterten Berechnungsformeln herangezogen werden. Wird an den Füßpunktwiderstand eine Gleichrichterdiode, z. B. eine Schottky-Diode angeschlossen, ergibt sich ein Spannungsteiler zwischen dem kurzen Dipol mit einer Serienkapazität und der Schottky-Diode mit einer Parallelkapazität und einem variablen Widerstand. Der variable Widerstand beeinflusst die Übertragungskennlinie zwischen der gleichgerichteten Ausgangsspannung und der Eingangswechselspannung der Schottky-Diode derart, dass sie für kleine Eingangswechselspannungen quadratisch und für große Eingangswechselspannungen linear verläuft. Die Veröffentlichung zeigt ferner, dass der Frequenzgang bei Frequenzen unterhalb von λ/8 praktisch linear verläuft, jedoch bei niedrigen Frequenzen durch eine Hochpasscharakteristik des Widerstandes der Schottky-Diode abfällt.

Im Ausführungsbeispiel wird für die Berechnung des Vektors ein Kugelkoordinatensystem zugrundegelegt. Die Berechnung des Betrages eines Vektors in kartesischen Koordinaten erfolgt nach $R = \sqrt{x^2 + y^2 + z^2}$, wobei R der Betrag und x, y und z die Komponenten in x-, y- und z-Richtung sind. Der Winkel in der x-y-Ebene errechnet sich nach φ = arctan y/x und der Neigungswinkel errechnet sich nach θ = arccos z/R.

Da der Mess-Dipol allerdings gegenüber der Drehachse, welche die z-Koordinate im Bezugskoordinatensystem bildet, geneigt ist, muss anschließend noch eine Rücktransformation des Winkels, unter dem die Messung erfolgt ist, in das Bezugskoordinatensystem erfolgen.

Da durch die Gleichrichtung nur positive Werte ermittelt werden und als Folge die Vorzeichen der gemessenen Komponenten verloren gehen, ergeben sich im dreidimensionalen Koordinatensystem $2^3$ Möglichkeiten, aus den Beträgen der Komponenten der elektrischen Feldstärke die Richtung des Vektors zu ermitteln. Diese werden allerdings auf die Hälfte reduziert, da der Feldstärkevektor eine Wechselgröße darstellt und somit . nur die Gerade von Interesse ist, auf der der seine Polarität im Takte der Feldfrequenz ändernde Vektor liegt. Man kann sich daher auf einen Halbraum z. B. z > 0 beschränken, um den gesuchten Feldvektor zu bestimmen.

Zur eindeutigen Richtungsbestimmung reicht es aus, in der x-y-Ebene das Maximum und das Minimum des Feldstärkevektors zu bestimmen. Man erhält dann zwei Winkel α für die Minimum-Messung und β für die Maximum-Messung nach der Formel α = arccos a/R und β = arccos b/R, wobei a die Feldstärkekomponente in Richtung Minimum-Messung, b die Feldstärkekomponente in Richtung Maximum-Messung und R den Feldstärkebetrag darstellt. Unter Berücksichtigung der Neigung des Dipols ergeben sich dann folgende Möglichkeiten für den Neigungswinkel θ:

$$\theta_{\beta1,2} = (90° - 35,26°) \pm \beta$$
$$\theta_{\beta3,4} = (\sim90° - 35,26°) \pm \beta$$
$$\theta_{\alpha1,2} = (\sim90° + 35,26°) \pm \alpha$$
$$\theta_{\alpha3,4} = (90° + 35,26°) \pm \alpha$$

Wegen der Beschränkung auf einen Halbraum kann θ auf ± 90° eingeschränkt werden. Dabei ergibt sich dann eine Schnittmenge von möglichen Vektoren, die nur in diesem Halbraum identisch oder nahezu identisch sind.

Fallen mehrere nahezu identische Ergebnisse in denselben Halbraum, so muss derjenige Wert aus der Schnittmenge ausgewählt werden, der den geringsten Fehler aufweist. Um eine Einschätzung des Fehlers vornehmen zu können, ist daher die Bestimmung der Fehlerfortpflanzung nötig. Dazu wird aus den einzelnen fehlerbehafteten Größen der Gesamtfehler der Messvorrichtung ermittelt.

Es handelt sich hierbei um Fehler, die sich aus der Maximumund Minimumsuche ergeben. Ferner ergeben sich Fehler aus einer Rauschspannung, die der eigentlichen Nutzspannung überlagert ist, sowie aus Nichtlinearitäten der Verstärker und des Analog-Digital-Wandlers.

Nachfolgend wird noch eine praktische Messung erläutert. Diese Messung wurde in einer TEM-Zelle mit der Bezeichnung GTEM 5305 bei einer Frequenz von 500 MHz und einer Feldstärke von 22,99 V/m durchgeführt. Der Schrittmotor vollführte dabei Schritte einer Schrittweite von 1,8°. Dabei ergaben sich für die Messung:

Minimum bei Schritt 6: a = 49 mV
Maximum bei Schritt 106: b = 154,5 mV

Betrag aus 3 um 120° verschobenen Messungen: R = 187,2 mV Verstärkungsfaktor ist 10, woraus eine Ungenauigkeit von 1,052 % folgt, entsprechend +/- 2,1 mV.

Der absolute Fehler für den Betrag errechnet sich zu: +/- 3,4 mV. Für die Winkel ergeben sich für das Minimum und das Maximum jeweils vier Werte:

$$\alpha = \text{arccos } a/R = 49/187,2 = 74,83°$$

$$\theta_1 = (-90° + 35,26) + \alpha = 20,09°$$
$$\theta_2 = (-90° + 35,26) - \alpha = -129,57°$$
$$\theta_3 = (90° + 35,26) + \alpha = 200,09°$$
$$\theta_4 = (90° + 35,26) - \alpha = 50,43°$$

$$\beta = \text{arccos } b/R = 154,5/187,2 = 34,38°$$

$$\theta_1 = (90° - 35,26) + \beta = 89,12°$$
$$\theta_2 = (90° - 35,26) - \beta = 20,36°$$
$$\theta_3 = (-90° - 35,26) + \beta = -90,88°$$
$$\theta_4 = \{-90° - 35,26) - \beta = -159,64°$$

Es brauchen nur die Winkel zwischen -90° > θ > 90° beachtet zu werden, so dass sich der gesuchte Winkel zu 20,09° oder 20,36° ergibt. Gewählt wird 20,36°, da für diesen Winkel die relativen Fehler der Ausgangsgrößen kleiner sind. Der absolute Folgefehler ergibt sich zu 2,1 Grad.

Ergebnis:

Betrag R = (187,2 +/- 3,4)mV
Winkel θ = (20,36 +/- 2,1)°
Winkel φ = 106 Schritte * 1,8° = 190,8° +/- Winkelauflösung

Mit dem Betrag von 187,2 mV (entspricht 45,4 dB/mV) wird der gesuchte Wert interpoliert. Dieser Wert wurde für 500 MHz aus einer Kalibrier-Tabelle entnommen, für 30 V/m sind es 49,2 dBmV und für 10 V/m sind es 37,3 dBmV). Eine lineare Interpolation führt dann auf das Endergebnis von 23,6 V/m. Dieser Wert hat zu Ausgangswert von 22,99 V/m nur eine Abweichung von 3 %.

**Patentansprüche**

1. Verfahren zur Ermittlung von gerichteten physikalischen Größen, die durch Vektoren eines wenigstens für die Dauer von vorgenommenen Messungen stationären harmonischen Vektorfeldes an einem Messort beschreibbar sind, durch Messen der an einem Messsensor für eine Koordinatenachse des Vektorfeldes entstehenden Messgröße in mehreren Koordinatenrichtungen sowie Berechnen des Betrages und der Richtung des Vektors, wobei der Betrag des Vektors durch Messungen seiner Komponenten in drei orthogonalen Koordinatenrichtungen ermittelt wird, die nacheinander durch Drehen desselben einzigen Messsensors um eine einzige Achse um jeweils 120° versetzt angefahren werden, wobei der Messsensor jeweils eine Neigung zur Drehachse von 90° - arctan $\sqrt{0,5}$ aufweist, **dadurch gekennzeichnet, dass** wenigstens zwei weitere Messungen von Komponenten des Vektors mit derselben Drehachse bei anderen Drehwinkeln vorgenommen werden und dass schließlich die eindeutige Richtung des Vektors über eine Schnittmenge aus den sich bei den Messungen·ergebenden mehrdeutigen Vektoren unterschiedlicher Richtungen ermittelt wird.

2. Verfahren nach Anspruch 1, **dadurch gekennzeichnet, dass** mittels einer rechnerisch oder empirisch ermittelten Übertragungsfunktion die physikalischen Größen der Vektorkomponenten aus gemessenen elektrischen Größen durch ein Messgerät oder einen Rechner bestimmt werden.

3. Verfahren nach Anspruch 1 oder 2, **dadurch gekennzeichnet, dass** als Messsensor ein elektrischer Dipol, in den als elektrische Größe eine Spannung influenziert wird, oder ein magnetischer Dipol dient, in den als elektrische Größe ein Strom induziert wird.

4. Verfahren nach einem der Ansprüche 1 bis 3, **dadurch gekennzeichnet, dass** die physikalischen Größen der Vektorkomponenten in ein Bezugs-Koordinatensystem übertragen werden, bei dem die Drehachse orthogonal zu einer Bezugsebene innerhalb des Bezugs-Koordinatensystems weist.

5. Verfahren nach einem der Ansprüche 1 bis 4, **dadurch gekennzeichnet, dass** die zwei weiteren Messungen von Komponenten des Vektors bei dem Maximum und dem Minimum des Messwertes über einer 360°-Drehung des Messsensors um dieselbe Drehachse vorgenommen werden.

6. Verfahren nach einem der Ansprüche 1 bis 5, **dadurch gekennzeichnet, dass** die Messungen von Komponenten des Vektors in wenigstens fünf über einer 360°-Drehung des Messsensors verteilten Drehpositionen vorgenommen werden und Zwischenwerte durch Interpolation ermittelt werden.

7. Verfahren nach einem der Ansprüche 4 bis 6, **dadurch gekennzeichnet, dass** die Fehlerfortpflanzung der einzelnen Fehler auf die Ergebnisse der mit dem einzigen Messsensor durchgeführten Messungen unterschiedlicher Richtungen bestimmt wird und aus der Schnittmenge der im selben Halbraum des Bezugs-Koordinatensystems liegenden Werte derjenige übernommen wird, der den geringsten relativen Fehler aufweist.

8. Vorrichtung zur Ermittlung von gerichteten physikalischen Größen, die durch Vektoren eines wenigstens für die Dauer von vorgenommenen Messungen stationären harmonischen Vektorfeldes an einem Messort beschreibbar sind, durch Messen der an einem Messsensor für eine Koordinatenachse des Vektorfeldes entstehenden Messgröße in mehreren Koordinatenrichtungen sowie Berechnen des Betrages und der Richtung des Vektors, wobei zur Erfassung der Komponenten des Vektors ein einziger Messsensor (10) vorgesehen ist, der um eine beliebig zu wählende Drehachse drehbar ist und die bei einer Messung des Messsensors (10) erfasste Koordinatenachse des Vektorfeldes mit dieser Drehachse einen Winkel von 90° - arctan $\sqrt{0,5}$ einschließt, **dadurch gekennzeichnet, dass** eine Steuerung und ein Antrieb (32) vorgesehen ist, mittels der der Messsensor (10) frei und für eine Messreihe von drei orthogonalen Komponenten um jeweils 120° um seine Drehachse versetzt positionierbar ist, dass der Messsensor (10) die in eine elektrische Größe umgesetzte physikalische Größe der gemessenen Vektorkomponente einem Messgerät (14) zuführt und dass die Steuerung und das Messgerät (14) mit wenigstens einem Steuerrechner (28) verbunden oder dessen Bestandteil sind, wobei ein Auswerterechner (36) den Betrag des Vektors durch Messungen seiner Komponenten in der Messreihe ermittelt und durch wenigstens zwei weitere Messungen von Komponenten des Vektors bei anderen Drehwinkeln mögliche Richtungen für den Vektor ermittelt und schließlich die eindeutige Richtung des Vektors über eine Schnittmenge aus den sich bei den Messungen ergebenden mehrdeutigen Vektoren unterschiedlicher Richtungen bestimmt.

9. Vorrichtung nach Anspruch 8, **dadurch gekennzeichnet, dass** der Messsensor (10) als elektrischer oder magnetischer Dipol ausgebildet ist.

10. Vorrichtung nach Anspruch 8 oder 9, **dadurch gekennzeichnet, dass** der Antrieb einen Schrittmotor (32) umfasst.

11. Vorrichtung nach einem der Ansprüche 8 bis 10, **dadurch gekennzeichnet, dass** ein Gleichrichter an einem Fußpunkt des Messsensors (10) angeschlossen ist und über eine symmetrische Widerstandsleitung (12) mit dem Messgerät (14) verbunden ist.

12. Vorrichtung nach einem der Ansprüche 8 bis 11, **dadurch gekennzeichnet, dass** der Messsensor (10), sein Antrieb (30, 32), das Messgerät (14) und der Steuerrechner (28) ein separates Modul (38) bilden, das über Lichtleiter mit dem Auswerterechner (36) verbunden ist.

## Claims

1. Method for determining vectored physical quantities, which can be represented by vectors of a harmonic vector field at a measuring position stationary at least for the duration of the measurements performed, by measuring in several coordinate directions the measured quantity arising on a sensor for a coordinate axis of the vector field and calculating the magnitude and direction of the vector, the magnitude of the vector being determined by measurements of its components in three orthogonal coordinate directions, which are moved up to successively by rotating the same single sensor about a single axis in each case displaced by 120°, the sensor in each case having an inclination relative to the rotation axis of $90°-\arctan\sqrt{0.5}$, **characterized in that** at least two further measurements of components of the vector are performed with the same rotation axis at other rotation angles and that finally the single-valued direction of the vector is determined by means of an intersection from the multi-valued vectors of different directions obtained during the measurements.

2. Method according to claim 1, **characterized in that** by means of a mathematically or empirically determined transfer function, the physical quantities of the vector components are determined from measured, electrical quantities by means of a measuring instrument or a computer.

3. Method according to claim 1 or 2, **characterized in that** the sensor is constituted by an electrical dipole in which a voltage is influenced as the electrical quantity, or alternatively a magnetic dipole in which a current is induced as the electrical quantity.

4. Method according to one of the claims 1 to 3, **characterized in that** the physical quantities of the vector components are transferred in a reference coordinate system, in which the rotation axis is directed orthogonally to a reference plane within the reference coordinate system.

5. Method according to one of the claims 1 to 4, **characterized in that** two further measurements of components of the vector are carried out at the maximum and minimum of the measured value by means of a 360° rotation of the sensor about the same rotation axis.

6. Method according to one of the claims 1 to 5, **characterized in that** measurements of components of the vector are performed in at least five rotation positions distributed over a 360° rotation of the sensor and intermediate values are determined by interpolation.

7. Method according to one of the claims 4 to 6, **characterized in that** the error propagation of the individual errors on the results of the measurements in different directions performed with the single sensor is determined and from the intersection of the values within the same half-space of the reference coordinate system, the value having the smallest relative error is taken over.

8. Device for determining vector physical quantities, which can be represented by vectors of a harmonic vector field at a measuring position stationary at least for the duration of the measurements performed, by measuring the measured quantity in several coordinate directions arising at a sensor for a coordinate axis of the vector field and calculating the magnitude and direction of the vector, a single sensor (10) being provided for the determination of the components of the vector and which is rotatable about a randomly selectable rotation axis and the coordinate axis of the vector field determined during a measurement of the sensor (10) forms an angle of $90°-\arctan\sqrt{0.5}$ with said rotation axis, **characterized in that** a control and a drive (32) is provided by means of which the sensor (10) is free and for a measurement series of three orthogonal components is positionable in offset manner by in each case 120° about its rotation axis, that the sensor (10) supplies the physical quantity of the measured vector component converted into an electrical quantity to a measuring instrument (14) and that the control and the measuring instrument (14) are connected to or form a component of at least one control computer (28), an evaluating computer (36) determining the amount of the vector by measurements of its components in the measurement series and by at least two further measurements of components of the vector at other rotation angles determines possible directions for the vector and finally determines the single-valued direction of the vector by means of an intersection of the multi-valued vectors of different directions obtained during the measurements.

9. Device according to claim 8, **characterized in that** the sensor (10) is constructed as an electrical or magnetic dipole.

10. Device according to claim 8 or 9, **characterized in that** the drive comprises a stepping motor (32).

11. Device according to one of the claims 8 to 10, **characterized in that** a rectifier is connected to a base of the sensor (10) and is connected by means of a symmetrical resistance line (12) to the measuring instrument (14).

12. Device according to one of the claims 8 to 11, **characterized in that** the sensor (10), its drive (30, 32), the measuring instrument (14) and the control computer (28) form a separate module (38) connected by means of light guides to the evaluating computer (36).

**Revendications**

1. Procédé de détermination de grandeurs physiques directionnelles pouvant être décrites à un endroit de mesure par des vecteurs d'un champ vectoriel harmonique stationnaire au moins pendant la durée des mesures effectuées, en mesurant la grandeur de mesure, qui se forme à un capteur de mesure, pour un axe des coordonnées du champ vectoriel dans plusieurs directions des coordonnées, ainsi qu'en calculant la valeur et la direction du vecteur, la valeur du vecteur étant déterminée par des mesures de ses composantes dans trois directions des coordonnées orthogonales, qui sont visées l'une après l'autre en tournant le même et unique capteur de mesure autour d'un axe unique de manière respectivement décalée de 120°, le capteur de mesure présentant respectivement une inclinaison de 90° - arctan √0,5 vers l'axe de rotation, **caractérisé en ce que** deux autres mesures au moins de composantes du vecteur sont effectuées avec le même axe de rotation, mais des angles de rotation différents et qu'une direction univoque du vecteur est déterminée à partir des vecteurs équivoques de directions différentes résultant des mesures par l'intermédiaire d'une intersection d'ensembles.

2. Procédé suivant la revendication 1, **caractérisé en ce que** les grandeurs physiques des composantes de vecteur sont déterminées par un appareil de mesure ou par un ordinateur à partir des grandeurs électriques mesurées au moyen d'une fonction de transfert déterminée par calcul ou de manière empirique.

3. Procédé suivant la revendication 1 ou 2, **caractérisé en ce qu'**un dipôle électrique dans lequel une tension est influencée en tant que grandeur électrique, ou un dipôle magnétique dans lequel un courant est induit en tant que grandeur électrique, sert de capteur de mesure.

4. Procédé suivant une des revendications 1 à 4, **caractérisé en ce que** les grandeurs physiques des composantes vectorielles sont transférées dans un système de coordonnées de référence, où l'axe de rotation s'étend orthogonalement à un plan de référence à l'intérieur d'un système de coordonnées de référence.

5. Procédé suivant une des revendications 1 à 4, **caractérisé en ce que** les deux autres mesures de composantes du vecteur sont effectuées au maximum et au minimum de la valeur de mesure sur une rotation de 360° du capteur de mesure autour du même axe de rotation.

6. Procédé suivant une des revendications 1 à 5, **caractérisé en ce que** les mesures de composantes du vecteur sont effectuées dans au moins cinq positions de rotation réparties sur une rotation de 360° du capteur de mesure et que des valeurs intermédiaires sont déterminées par interpolation.

7. Procédé suivant une des revendications 4 à 6, **caractérisé en ce qu'**est déterminée la propagation de l'erreur des différentes erreurs aux résultats des mesures effectuées dans différentes directions au moyen de l'unique capteur de mesure et **en ce qu'**à partir de l'intersection d'ensembles des valeurs se trouvant dans le même demi-espace du système de coordonnées de référence est prise en considération celle qui présente l'erreur relative la plus faible.

8. Dispositif de détermination de grandeurs physiques directionnelles pouvant être décrites à un endroit de mesure par des vecteurs d'un champ vectoriel harmonique stationnaire au moins pendant la durée des mesures effectuées, en mesurant la grandeur de mesure, qui se forme à un capteur de mesure, pour un axe des coordonnées du champ vectoriel dans plusieurs directions des coordonnées, ainsi qu'en calculant la valeur et la direction du vecteur, pour la saisie des composantes du vecteur, étant prévu un unique capteur de mesure (10), qui peut tourner autour de n'importe quel axe de rotation à sélectionner, l'axe des coordonnées du champ vectoriel, capté lors d'une mesure par le capteur de mesure, enfermant avec cet axe de rotation un angle de 90° - arctan $\sqrt{0,5}$, **caractérisé en ce qu'**une commande et un entraînement (32) sont prévus, au moyen desquels le capteur de mesure (10) est positionnable librement et décalé de 120° respectivement autour de son axe de rotation pour une série de mesure de trois composantes orthogonales, que le capteur de mesure (10) amène la grandeur physique de la composante du vecteur mesurée, convertie en une grandeur électrique, à un appareil de mesure (14) et que la commande et l'appareil de mesure (14) sont reliés à un ordinateur de commande (28) au moins ou font partie intégrante de celui-ci, un ordinateur d'évaluation (36) déterminant la valeur du vecteur par des mesures de ses composantes dans la série de mesure, ainsi que les directions possibles pour le vecteur avec d'autres angles de rotation par deux autres mesures au moins et enfin la direction univoque du vecteur par l'intermédiaire d'une intersection d'ensembles de vecteurs équivoques de différentes directions résultant des mesures.

9. Dispositif suivant la revendication 8, **caractérisé en ce que** le capteur de mesure (10) est conçu comme dipôle électrique ou magnétique.

10. Dispositif suivant la revendication 8 ou 9, **caractérisé en ce que** l'entraînement comprend un moteur pas à pas (32).

11. Dispositif suivant une des revendications 8 à 10, **caractérisé en ce qu'**un redresseur de courant est raccordé à un point de base du capteur de mesure (10) et à l'appareil de mesure (14) par l'intermédiaire d'une ligne de résistance symétrique (12).

12. Dispositif suivant une des revendications 8 à 11, **caractérisé en ce que** le capteur de mesure (10), son entraînement (30, 32), l'appareil de mesure (14) et l'ordinateur de commande (28) forment un module (38) séparé, qui est relié à l'ordinateur d'évaluation (36) par l'intermédiaire de conducteurs optiques.

Fig. 1

Fig. 2